# EUROPEAN PATENT APPLICATION

(11) **EP 2 983 196 A1**
(43) Date of publication of application: **10.02.2016**
(21) Application number: 14180191.0
(22) Date of filing: 07.08.2014
(51) Int. Cl.: H01L 21/28, H01L 29/423, H01L 29/66, H01L 27/115

(54) **A method for manufacturing a floating gate memory element**

(71) Applicant: IMEC VZW, 3001 Leuven (BE)
(72) Inventor: Blomme, Pieter, 3001 Leuven (BE)
(74) Representative: Awapatent AB

(57) **Abstract**

A method for manufacturing a floating gate memory element is disclosed. The method (200) comprising forming (202) a stack of horizontal layers (100) arranged on top of each other, the stack of horizontal layers (100) comprising alternating sacrificial layers of a first type (102) and sacrificial layers of a second type (104); forming (204) a vertical opening (106) through said horizontal stack of layers (100), wherein said vertical opening (106) comprises a sidewall surface (108), forming (206) a first vertical dielectric layer (110) on said sidewall surface (108), forming (208) a vertical floating gate layer (112) on said first vertical dielectric layer (110), forming (210) a second vertical dielectric layer (114) on said vertical floating gate layer (112), filling (211) said vertical opening (106) with a channel material (107), forming (212) cavities of a first type (105) in said sacrificial layers of the second type (104), said cavities (105) being adjacent to said first vertical dielectric layer (110), removing (214) portions of said first vertical dielectric layer (110) and said vertical floating gate layer (112) at locations adjacent to said cavities of the first type (105) thereby extending said cavities of the first type (105) such that said second vertical dielectric layer (114) is exposed, filling (216) said extended cavities of the first type (105) with an isolating material (116), forming (218) cavities of a second type (117) in said sacrificial layers of the first type (102), said cavities of the second type (117) being adjacent to and exposing said first vertical dielectric layer (110), forming (220) a third dielectric layer (118) in said cavities of the second type (117), said third dielectric layer (118) being formed on said first vertical dielectric layer (110), forming (222) a conductive material (120) in said cavities of the second type (117), said conductive material (120) being in contact with said third dielectric layer (118).

## Description

### FIELD OF THE INVENTION

The present invention relates to the manufacturing of a floating gate memory element.

### BACKGROUND

There is a continuous need for increasing the bit density and reducing the bit cost for memory devices, and new alternatives such as flash memories are developed for ultra-high density memory applications. Flash memories are electronic non-volatile memories that can be electrically erased and reprogrammed.

Flash memories, such as NAND or NOR type flash memories, commonly store information in an array of memory cells made from floating-gate transistors, where each memory cell typically stores one bit of information. In these flash memories, each memory cell resembles a standard metal-oxide-semiconductor field-effect transistor, MOSFET, but comprises a floating gate in addition to the control gate. The floating gate is isolated from its surrounding by an isolating layer, typically an oxide layer. The floating gate is further interposed between the control gate and the MOSFET channel. Because the floating gate is electrically isolated by the isolation layer, electrons may be stored in the floating gate whereby the memory function of the flash memory is provided.

The manufacturing of flash memories comprising floating gates involves complex processing in order to form the floating gates, i.e. the memory cells of the flash memory needs to be separated from each other in order to provide isolated floating gates. There is therefore a need for efficient and cost-effective methods for manufacturing three-dimensional stacked memories comprising floating gates.

To this end, US 2013/0341701 A1 discloses a vertical semiconductor memory device and manufacturing method thereof.

### SUMMARY OF THE INVENTION

An object of the present invention is to provide an efficient and cost-effective method for manufacturing a floating gate memory element with increased bit density.

According to a first aspect of the present invention a method for manufacturing a floating gate memory element is provided. The method comprising forming a stack of horizontal layers arranged on top of each other, the stack of horizontal layers comprising alternating sacrificial layers of a first type and sacrificial layers of a second type; forming a vertical opening through said horizontal stack of layers, wherein said vertical opening comprises a sidewall surface, forming a first vertical dielectric layer on said sidewall surface, forming a vertical floating gate layer on said first vertical dielectric layer, forming a second vertical dielectric layer on said vertical floating gate layer, filling said vertical opening with a channel material, forming cavities of a first type in said sacrificial layers of the second type, said cavities being adjacent to said first vertical dielectric layer, removing portions of said first vertical dielectric layer and said vertical floating gate layer at locations adjacent to said cavities of the first type thereby extending said cavities of the first type such that said second vertical dielectric layer is exposed, filling said extended cavities of the first type with an isolating material, forming cavities of a second type in said sacrificial layers of the first type, said cavities of the second type being adjacent to and exposing said first vertical dielectric layer, forming a third dielectric layer in said cavities of the second type, said third dielectric layer being formed on said first vertical dielectric layer, forming a conductive material in said cavities of the second type, said conductive material being in contact with said third dielectric layer.

The present invention is based on the realization that by forming a first vertical dielectric layer and a third dielectric layer the formation of the floating gate memory element may be improved as the physical properties of the floating gate memory element are better controlled. In other words, problems associated with undercutting of the first vertical dielectric layer during fabrication of the floating gate memory may be reduced. A more well-defined floating gate memory element may thereby be obtained.

Additionally, a more reliable interface between the vertical floating gate layer and the first vertical dielectric layer may be obtained. The physical size of the floating gate memory element may as a consequence be reduced which increases the bit density of a memory comprising the floating gate memory element.

The wording *sacrificial layer* should here be construed as a layer introduced in the process of manufacturing a floating gate memory element in order to enable further processing steps. Hence, the *sacrificial layer* should be understood as a dummy layer that is at least partly removed and at least partly replaced in a later processing step. The *sacrificial layer* does not provide any functionality to the manufactured floating gate memory element.

The wording *vertical* in vertical dielectric layer should be construed as a dielectric layer vertically extending along said sidewall surface.

Said removing of portions of said first vertical dielectric layer and said vertical floating gate layer may comprise isotropic etching.

The use of an isotropic etching is advantageous in that it reduces the complexity of the processing needed for manufacturing the floating gate memory element.

Said first vertical dielectric layer and said third dielectric layer may be formed with a total thickness tₜₒₜ and wherein a thickness of said first vertical layer t₁ may be in the range of 20 - 60 % of the total thickness tₜₒₜ.

The total thickness tₜₒₜ is here to be understood as the thickness of the first vertical dielectric layer and the third dielectric layer in a direction substantially perpendicular to the horizontal stack of layers.

A thinner first vertical dielectric layer may be used by having a thickness of the first vertical dielectric layer that only corresponds to a portion of the total thickness tₜₒₜ during the manufacturing of the floating gate memory element. The use of a thinner first vertical dielectric layer reduces problems associated with damage to or the removing of portions of the first vertical dielectric layer at locations in between the second vertical dielectric layer and the respective sacrificial layers of the first type. The total thickness tₜₒₜ of the dielectric layers contributes to a desired isolation of the vertical floating gate layer of the floating gate memory element. In other words, tunnelling of charges trough the dielectric layers is mitigated.

The method may further comprise removing of said first vertical dielectric layer at exposed locations of said first vertical dielectric layer prior to forming said third dielectric layer, said third dielectric layer being formed with a total thickness tₜₒₜ.

This is advantageous as a continuous third dielectric layer may be formed adjacent to the vertical floating gate layer, i.e. an interface between the first vertical dielectric layer and the third dielectric layer is avoided. Charge leakage at the interface between the dielectric layers may thereby be reduced.

The total thickness tₜₒₜ may be within the range of 10 - 20 nm.

The total thickness tₜₒₜ contributes to a desired isolation of the vertical floating gate layer of the floating gate memory element from the surrounding environment. This increases the retention of the floating gate memory comprising the floating gate memory element.

The vertical floating gate layer may be formed with a thickness within the range of 1 - 5 nm.

These vertical floating gate layer thicknesses provide efficient charge storage capacity of the vertical floating gate layer while capacitive coupling and interference between adjacent vertical floating gate layers is mitigated.

The second vertical dielectric layer may be formed with a thickness within the range of 6 - 10 nm.

This thickness provides proper isolation of the vertical floating gate layer while allowing for tunnelling of charges through the second vertical dielectric layer during for example writing to or reading of the charge in the vertical floating gate layer.

The conductive material may comprise a metal. Using a metal is advantageous as it allows for tailoring of the work function which offers reduction of undesirable injection of carriers from the metal (acting as a control gate) into the vertical floating gate layer (acting as a floating-gate) during the erase operation of a floating gate memory comprising the floating gate memory element. Furthermore, it is desirable that the conductive material has a low resistivity, in order to limit the total resistance of this layer.

The forming of said third dielectric layer may comprise forming a plurality of dielectric layers. Using a plurality of layers allows for improvement of the material quality of the third dielectric layer and a reduction of the thickness of the third dielectric layer while preserving an adequate barrier against tunnelling and other leakage through this layer. This may improve the electrical performances of the floating gate memory element without degrading the retention characteristics, i.e. the storing of charges. In other words, this reduces charge leakage through the third dielectric layer.

The forming of said vertical floating gate layer may comprise forming a semiconductor layer and a metal comprising layer. This is advantageous as charge leakage to and from the vertical floating gate layer is reduced.

The channel material may comprise an amorphous semiconductor material.

The method may further comprise transforming said amorphous semiconductor material to a poly-crystalline semiconductor material or a single-crystalline semiconductor material.

The described steps of filling said vertical opening with a channel material comprising an amorphous semiconductor material and transforming said channel material to a poly-crystalline semiconductor material or a single-crystalline semiconductor material are advantageous as a vertical opening with increased mobility and reduced concentration of defects may be obtained.

Further features of, and advantages with, the present invention will become apparent when studying the appended claims and the following description. The skilled person will realize that different features of the present invention may be combined to create embodiments other than those described in the following, without departing from the scope of the present invention.

### BRIEF DESCRIPTION OF THE DRAWINGS

This and other aspects of the present invention will now be described in more detail, with reference to the enclosed drawings showing embodiments of the invention.
Figure 1 illustrates a side view of a preliminary stage of a floating gate memory element according to prior art.
Figures 2 - 8 illustrates side views of preliminary stages of a floating gate memory element corresponding to different processing steps according to an embodiment of the present invention.
Figure 9 illustrates a side view of a final stage of a floating gate memory element according to an embodiment of the present invention.
Figure 10 illustrates a side view of a final stage of a floating gate memory element according to another embodiment of the present invention.
Figure 11 illustrates a flow chart of the method according to the invention.

### DETAILED DESCRIPTION

The present invention will now be described more fully hereinafter with reference to the accompanying drawings, in which currently preferred embodiments of the invention are shown. This invention may, however, be embodied in many different forms and should not be construed as limited to the embodiments set forth herein. These embodiments are rather provided for thoroughness and completeness, and for fully conveying the scope of the invention to the skilled person.

It will be understood that the terms *vertical* and *horizontal* are used herein refer to particular orientations of the figures and these terms are not limitations to the specific embodiments described herein.

The terms *first, second* and the like in the description are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The terms so used are interchangeable under appropriate circumstances and the embodiments of the invention described herein can operate in other orientations than described or illustrated herein.

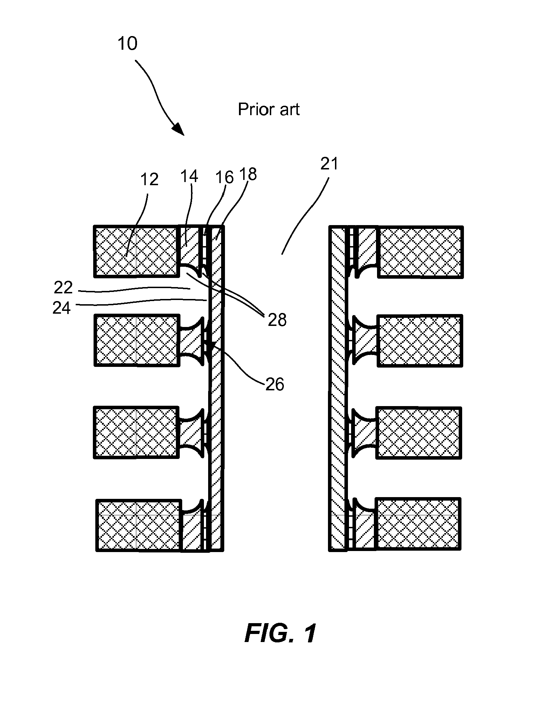

Figure 1 illustrates a side view of a preliminary stage of a floating gate memory element according to prior art. This preliminary stage of the floating gate memory element 10 comprises a horizontal layer 12, a first dielectric layer 14, a floating gate layer 16, and a second dielectric layer 18, sandwiched in between the horizontal layer 12 and an opening 21. Portions 22, 24 of the first dielectric layer 14 and the floating gate layer 16 respectively have at this preliminary stage of the floating gate memory element been removed in order to form isolated regions or portions 26 of the these layers. In a later stage of the manufacturing of a floating gate memory element, these isolated regions 26 correspond to memory cells comprising control-gates and floating gates of the floating gate memory.

The first dielectric layer 14 is often referred to as interpoly dielectric, IPD, or intergate dielectric IGD. The IGD layer provides retention of charges in the floating gates. The IGD layer also facilitates capacitive coupling between a control gate and the floating gate which allows for assessment or programming of the charge state of the floating gate.

The floating gates serve as the charge storage nodes of the floating gate memory. Charges stored in the floating gate provide the non-volatile memory function of the memory, i.e. the memory may retain stored information in absence of power. Therefore, the floating gate has to be patterned so that each memory cell (corresponding to each crossing of an opening 21 with a floating gate layer later arranged at the location of the horizontal layer 12) comprises one isolated floating gate region 26.

A problem when forming the isolated regions 26 of the layers 14, 16 is that the first dielectric layer 14 and the floating gate layer 16 are undercut during the process such that non-uniform recesses 28 are formed. This is a result of the substantially isotropic processes used for forming the isolated regions 26, i.e. processes involving substantially isotropic etching and/or oxidation techniques.

The forming of a non-uniform recess 28 depends sensitively on several factors during the processing such as the dimensions of the layers and the atomic structure and composition of the materials used in the floating gate memory element. Processing parameters, such as the composition of the etchant, the temperature, the etching time, and the availability of the etchant during processing also influence the shape of the recesses 28. The resulting recesses 28 therefore differ in size and shape which leads to memory cells having varying dimensions and electronic properties. This may further result in increased charge leakage and parasitic capacitance coupling between different memory cells, as well as varying coupling ratios and thresholds for operation for the individual memory elements. This reduces the performance and reliability of floating gate memories.

It is an object of the present invention to provide a method for manufacturing a floating gate memory element which offers substantially reduced charge leakage, improved reliability and allows for improved density. A floating gate memory comprising such a memory element therefore has improved performance.

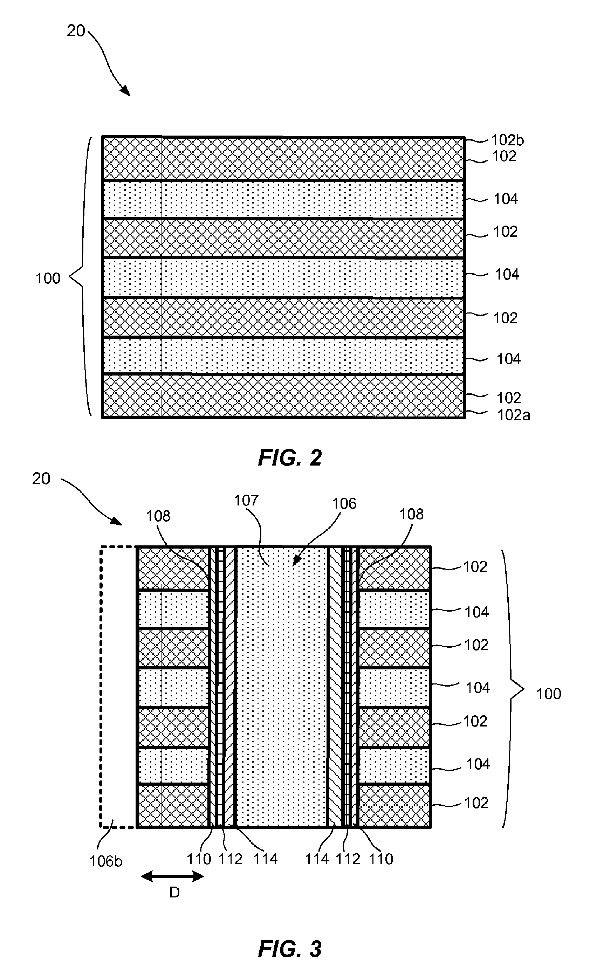

A method 200 for manufacturing a floating gate memory element in accordance with the present invention will now be described with reference to figures 2 to10 which illustrate a plurality of manufacturing steps in more detail.

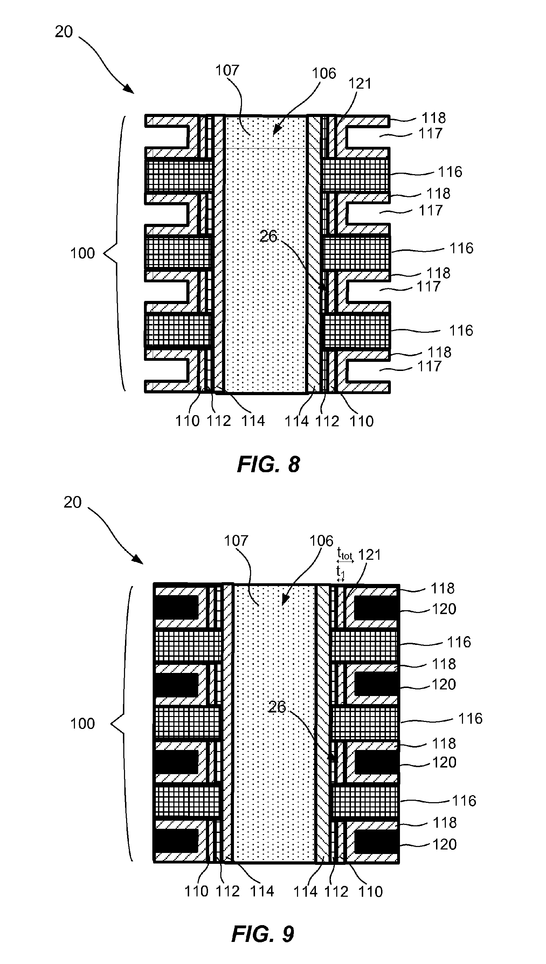

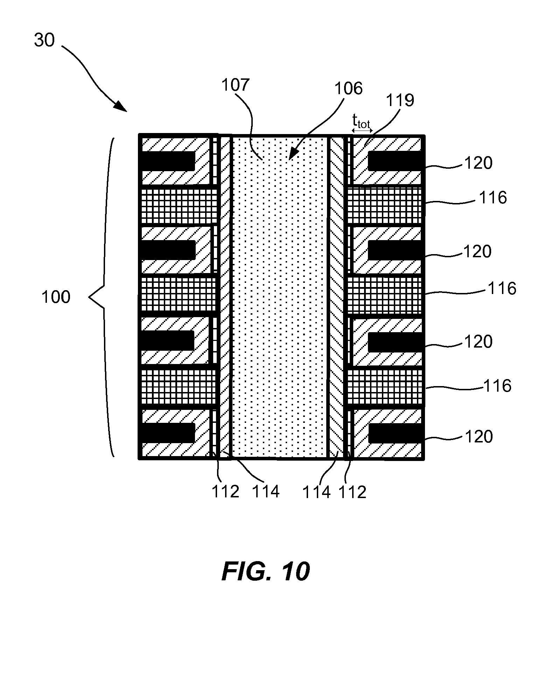

Figures 2 to 8 shows side views of preliminary stages of the floating gate memory element. Figure 9 illustrates a final stage of the floating gate memory element according to one embodiment of the present invention. Figure 10 illustrates a final stage of the floating gate memory element according to another embodiment of the present invention.

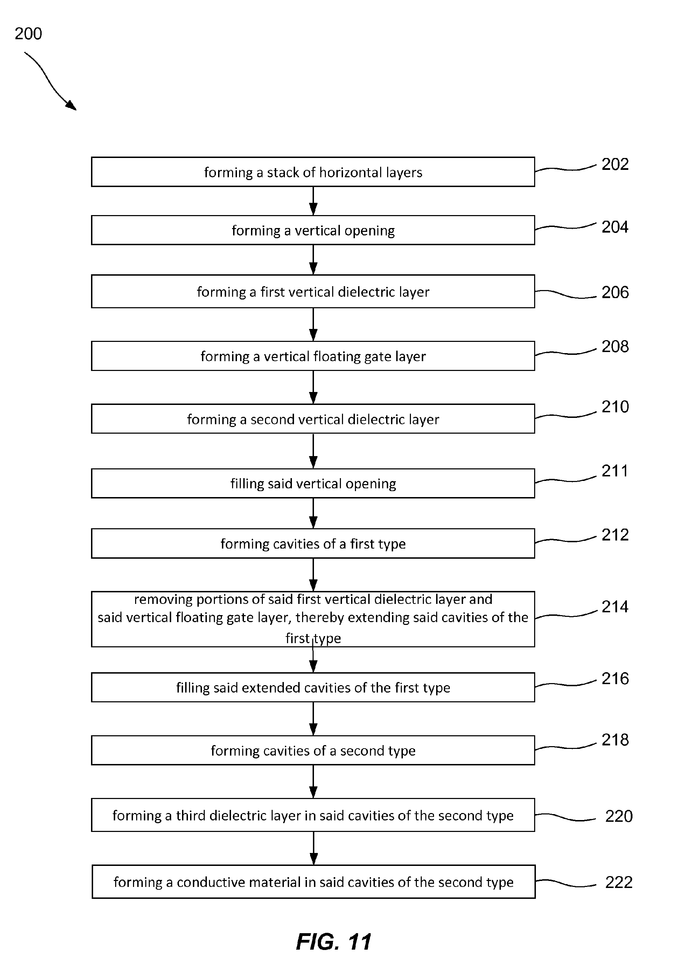

The flow chart in figure 11 illustrates the method 200 comprising a plurality of manufacturing steps for a floating gate memory element in accordance with the present invention.

Now referring to the figures, and to figure 2 in particular, the first step for manufacturing a floating gate memory element 20 comprises forming 202 a stack of horizontal layers 100 arranged on top of each other, the stack of horizontal layers 100 comprising alternating sacrificial layers of a first type 102 and sacrificial layers of a second type 104.

The stack of layers 100 may be formed using standard deposition techniques known to a person skilled in the art, such as, for example, chemical vapour phase deposition (CVD), more preferably, low pressure CVD (LPCVD) or alternatively plasma enhanced CVD (PECVD).

The stack of layers 100 may comprise silicon oxide and silicon nitride based layers. According to one embodiment of the present invention the stack of horizontal layers may be formed on a semiconductor substrate. The semiconductor substrate comprises a semiconducting material, for example, a silicon substrate.

In order to manufacture a floating gate memory, a vertical transistor with at least one associated vertical opening is needed. For this, a stack of gates is provided where the gates will be formed of conductive layers at locations corresponding to the positions of the sacrificial layers of a first type 102. Each gate acts as a control gate except the lowermost gate, corresponding to the position of the lowermost sacrificial layers of a first type 102a of the stack of layers 100, which takes a role of a lower select gate, and the uppermost gate, corresponding to the upper sacrificial layers of a first type 102b, which takes a role of upper select gate.

Alternatively, for example, in case of a pipe-BiCS semiconductor device, the uppermost gate may act as both the lower and upper select gates.

In between the lower and upper select gates, a number of control gates comprising conductive layers are provided, at positions within the stack of layers 100 which correspond to the sacrificial layers of a first type 102, in between the lowermost and uppermost sacrificial layers of a first type 102a, 102b. The number of control gates, set by the number of sacrificial layers of a first type 102, in between the lowermost and uppermost sacrificial layers of a first type 102a, 102b, determines the bit density of the final floating gate memory. By adding more sacrificial layers of a first type, and forming control gates comprising conductive layers, the bit density may be increased without adding more complexity to the process flow of the memory device.

In its simplest form, the stack of layers 100 may only comprise three sacrificial layers of the first type 102, subsequently resulting in three conductive layers, where the lowermost conductive layer forms a lower select gate, the uppermost conductive layer forms an upper select gate, and a middle conductive layer which forms a control gate. For a higher density of the memory device, the stack of layers 100 preferably comprises between about 8 up to 64, or even more, sacrificial layers of a first type 102 subsequently resulting in the same number of conductive layers.

A vertical opening 106 is formed 204 through the horizontal stack of layers 100, see figure 3. The vertical opening 106 is shown as being filled with a channel material 107 which will be discussed further below.

The vertical opening 106 may be a hole or a trench extending through the stack of layers 100.

In the vertical opening 106, a vertical channel region of the floating gate vertical semiconductor or memory device will be formed. Preferably, a plurality of openings or holes for the transistor channel is formed through the stack of layers 100. The formation of each vertical opening 106 may be achieved using standard process techniques known to a person skilled in the art. By providing a vertical opening 106 through the stack of layers 100 part of the stack of layers 100 is removed, more specifically, parts of the alternating sacrificial layers of a first type 102 and sacrificial layers of a second type 104 are removed.

A plurality of layers is formed on a side wall surface 108 of the vertical opening 106 after the forming the vertical opening 106, as illustrated in figure 3. The forming of the layers comprises forming 206 a first vertical dielectric layer 110, forming 208 a vertical floating gate layer 112 on the first vertical dielectric layer 110, and forming 210 a second vertical dielectric layer 114 on the vertical floating gate layer 112.

In a later stage of the fabrication of the floating gate memory, isolated regions of the first vertical dielectric layer 110 will constitute part of the IGD layer, also referred to as the charge blocking layer. The second vertical dielectric layer 114 will constitute the so-called charge tunnelling layer of the floating gate memory. The name originates from the fact that the erase operation and in some cases, the program operation, occurs through this dielectric layer using quantum mechanical tunnelling. In between the vertical dielectric layers 110 and 114 the vertical floating gate layer 112 will constitute the floating gate, of the floating gate memory.

The first vertical dielectric layer 110 may comprise a stack of a nitride containing dielectric layer sandwiched in between two oxygen containing dielectric layers, not shown. For example, a stack of a Si₃N₄ layers may be sandwiched in between two SiO₂ layers. Such a stack is often referred to as the ONO or oxygen/nitride/oxygen stack.

According to another embodiment, the first vertical dielectric layer may comprise a high-k dielectric layer such as Al₂O₃, HfAlO or HfO₂.

According to yet another embodiment, the first vertical dielectric layer may be a thin (<5nm) SiO₂ layer.

The second vertical dielectric layer 114 may comprise SiO₂.

The method 200 for manufacturing a floating gate memory element further comprises filling 211 the vertical opening 106 with a channel material 107, as illustrated in figure 3.

The filling 211 of the vertical opening 106 is performed after the forming 210 of the second vertical dielectric layer 114.

The channel material 107 may comprise an amorphous semiconducting material, such as, for example, amorphous silicon (a-Si). The channel material 107 may be the same material as the material of the semiconductor substrate. The channel material 107 may be a poly-crystalline or mono-crystalline semiconductor material. Filling 211 of the vertical opening 106 may be done using chemical vapour deposition (CVD), or more preferably, low pressure chemical vapour deposition (LPCVD). Alternatively, the channel material 107 may be provided into the hole using gas cluster ion beam deposition (GCIB). Alternatively, the channel material 107 may be provided into the hole by selective epitaxial growth, using techniques such as molecular beam epitaxy (MBE) or metallo-organic chemical vapour deposition (MOCVD).

After filling the vertical opening 106 the method 200 may further comprise the step of transforming (not shown) the amorphous semiconductor material to a poly-crystalline or single-crystalline semiconductor material. In other words, the amorphous semiconducting material used to fill the vertical opening 106 may be converted into a poly- or mono-crystalline semiconducting material. For example, the channel material 107 may consist of amorphous silicon (a-Si) and may be converted into mono-crystalline silicon (c-Si). The conversion may be done by using, for example, solid phase epitaxial regrowth (SPER).

After the formation of the vertical opening 106, the layers 110, 112, and 114, and the filling of the vertical opening 106, an additional opening 106b, is formed through the stack of layers 100 at a distance D from the vertical opening 106, thereby exposing the side of the stack of layers 100 to further processing, see figure 3.

According to preferred embodiments, the distance D is greater than 0.

The distance D is preferably smaller than 50 nm, more preferably smaller than 30 nm, even more preferably smaller than 20 nm, even more preferably smaller than 10 nm. In other words, a stack of layers 100 comprising the alternating sacrificial layers of a first type 102 and sacrificial layers of a second type 104 will be present in between the vertical opening 106 and the additional opening 106b.

In another embodiment, the additional opening may be provided in between two adjacent channel regions (not shown).

The additional opening may be created through using similar techniques as during the formation the vertical opening 106. The additional opening may also be a trench.

The formation of the additional opening may be done using standard process techniques known to a person skilled in the art.

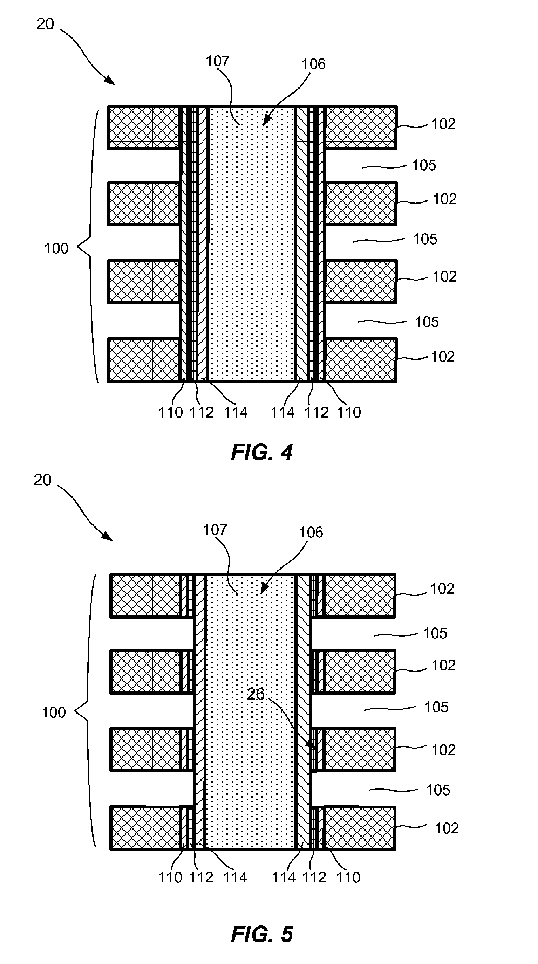

By use of the additional opening, a step of forming 212 cavities of a first type 105 in the sacrificial layers of the second type 104 is performed. The cavities 105 are formed adjacent to the first vertical dielectric layer 110. The forming 212 of the cavities 105 may be performed by etching the sacrificial layers of the second type 104. The resulting structure is illustrated in figure 4.

During the forming of the cavities 105, at least a portion of the first vertical dielectric layer 110 which is in contact with the sacrificial layers of the second type 104 may be affected or partially etched. The vertical floating gate layer 112 may also be partially or completely etched in the regions of the stack of layers 100 corresponding to the location of the etched away portions of the sacrificial layers of a second type 104. The second vertical dielectric layer 114 may also be affected or partly removed during the etching. As it is a primary goal to remove, or alter the vertical floating gate layer 112 and to remove the first vertical dielectric layer 110 in a later step, it may be advantageous that the etching step of the sacrificial layers of a second type 104 also affects at least parts of the layers 110 and 112.

In other embodiments, the part of the vertical floating gate layer 112 that corresponds to the cavities 105 is not fully removed during the etching of the sacrificial layers of the second type 104. In that case, an additional etching step is performed in order to remove the aforementioned part of the vertical floating gate layer 112.

Figure 5 illustrates the floating gate memory element 20 after a step of removing 214 portions of the first vertical dielectric layer 110 and the vertical floating gate layer 112 at locations adjacent to the cavities of the first type 105 has been performed. As a result the cavities of the first type 105 are extended such that the second vertical dielectric layer 114 is exposed.

The structure resulting from the steps 212 and 214 provides isolated regions 26 comprising portions of the layers 110 and 112. As discussed above these isolated regions 26 will in a later stage of the fabrication of the floating gate memory constitute the IGD and the floating gates of the floating gate memory.

The sacrificial layers of a second type 104 of the stack 100 of layers, the vertical floating gate layer 112, and the first vertical dielectric layer 110 may be removed by isotropic etching. The etching may be dry or wet etching. For example, a hydrogen fluoride, HF, etching may be used for removing the layers 104, 110 and 112 at locations adjacent to the formed cavities of the first type 105. The etching of the sacrificial layers of a second type 104 should, however, preferably not affect the sacrificial layers of a first type 102 of the stack 100 of layers.

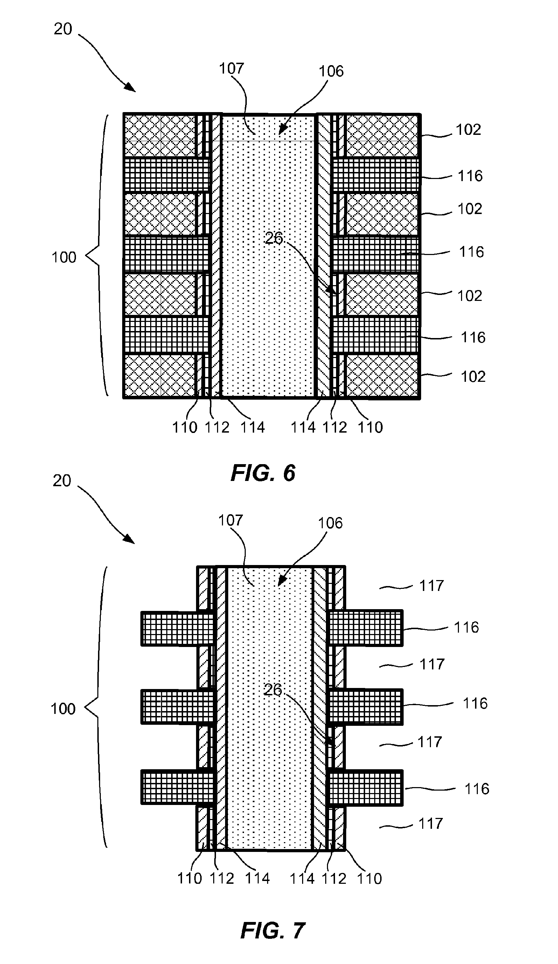

A step of filling 216 the extended cavities of the first type 105 with an isolating material 116 is performed after the steps of forming 212 cavities of a first type 105 and extending 214 the cavities of the first type 105, as illustrated in figure 6.

The isolating material 116 is electrically isolating.

It should be noted that at least a portion of each of the extended cavities is filled during step 216 such that neighbouring memory cells are electrically isolated from each other by the isolating material 116, i.e. the isolated regions 26 are isolated from each other by the isolating material 116.

The additional opening, not shown may also be filled after the formation of the floating gate memory element. According to one embodiment the cavities 105 and the additional opening may be filled with the same isolating material 116. The isolating material 116 may comprise SiO₂ or a low-k dielectric material.

Figure 7 illustrates the floating gate memory element 20 after a step of forming 218 of cavities of a second type 117 in the sacrificial layers of the first type 102. The cavities of the second type 117 are adjacent to and exposing the first vertical dielectric layer 110 of the isolated regions 26.

In figure 8, a step of forming 220 a third dielectric layer 118 in the cavities of the second type 117 has been performed. As can be seen in the figure, the third dielectric layer 118 is formed on the first vertical dielectric layer 110. The third dielectric layer 118 may additionally be formed on interfaces of the isolating material 116 whereby the cavities 117 are reduced in size.

The purpose of the steps of forming 218 cavities of the second type 117 and forming 220 of an the third dielectric layer 118, as illustrated in figure 8, is to provide an efficient IGD layer, i.e. a dielectric layer having a sufficient thickness in order to provide a high retention for the floating gate, i.e. the vertical floating gate layer 112, of the floating gate memory element 20.

It is an advantage of the present method 200 to initially provide a thin first vertical dielectric layer 110, which then, in a later stage, is increased in thickness by adding the third dielectric layer 118. The initially thinner first vertical dielectric layer 110 reduces problems associated with uncontrolled under-cutting of the first vertical dielectric layer 110 during the manufacturing of the floating gate memory element 20. This initial dielectric layer 110 is however too thin to provide a desired isolation during operation of the floating gate of the floating gate memory element 20. By adding the third dielectric layer 118 to the first vertical dielectric layer an improved isolation of the charges in the floating gate may be provided.

According to one embodiment the third dielectric layer 118 comprises the same dielectric material as the first vertical dielectric layer 110.

According to another embodiment, the third dielectric layer 118 comprises two distinct dielectric layers, wherein the layer that will be in contact with the control gate regions is made of substantially the same dielectric material as the first vertical dielectric layer 110.

The first 110 and the third 118 dielectric layers may comprise a stack of layers comprising oxide-nitride-oxide layers, i.e. ONO-layers, comprising for example SiO₂ and Si₃N₄. The first 110 and the third 118 dielectric layers may alternatively comprise SiO₂, and HfAlO or HfO₂.

According to one embodiment the first vertical dielectric layer 110 and the third dielectric layer 118 are formed with a total thickness tₜₒₜ and wherein a thickness of the first vertical layer t₁ is in the range of 20 - 60 % of the total thickness tₜₒₜ.

The forming 220 of the third dielectric layer 118 may comprise forming a plurality of dielectric layers, not shown. This is advantageous as the formation of the plurality of layers may result in a third dielectric layer 118 having improved insulating properties, i.e. reduced charge leakage. Hence the retention of the floating gate memory may be improved.

According to a preferred embodiment the plurality of dielectric layers comprises 5nm of HfAlO, 5nm of SiO₂, and 5nm of HfAlO. According to another preferred embodiment, the first vertical dielectric layer 110 comprises 5nm of HfAlO, and the plurality of dielectric layers comprises 5nm of SiO₂, and 5nm of HfAlO.

The method 200 further comprises forming 222 a conductive material 120, corresponding to the control gate of the floating gate memory element, in the cavities of the second type 117. The conductive material 120 is in contact with the third dielectric layer 118. Figure 9 illustrates a final stage of a floating gate memory element after the forming of the conductive material 120 in the cavities 117.

By forming the cavities of a second type 117, thereby removing a portion of the sacrificial layers of a first type 102, and subsequently providing a conductive material 120 in the removed portions allows for use of metal gate processes having a lower thermal-budget.

These processing steps are commonly referred to as replacement metal gate, RMG, processing. RMG broadens the range of material options for work-function tuning and reliability control. Further advantages are a lower gate resistance and a tool for providing mobility improvement.

Through the use of a conductive material 120 a control gate structure is formed for controlling the conductance of the vertical opening 106. The conductive material 120 further allows for a reduced resistivity of the control gate structure which improves the speed at which a floating gate memory comprising the floating gate memory element 20 may be controlled.

The conductive material 120 may comprise a metal. The metal may be selected from a group of metals comprising but not limited to tungsten, titanium nitride, tantalum nitride or copper.

According to another embodiment of the present invention the method 200 further comprises removing of the first vertical dielectric layer 110 at exposed locations of the first vertical dielectric layer 110 prior to forming the third dielectric layer 118. The third dielectric layer 118 then has a total thickness tₜₒₜ.

Figure 10 illustrates a floating gate memory element 30 resulting from such a process. This manufacturing step is advantageous as a continuous dielectric layer 119 may be formed directly adjacent to the vertical floating gate layer 112, i.e., the interface 121 between the first vertical dielectric layer 110 and the third dielectric layer 118 of figure 9, is avoided. Charge leakage at the interface between the dielectric layers may thereby be reduced.

The total thickness tₜₒₜ may be within the range of 10 - 20 nm, as this range of thickness provides a desired isolation of the floating gate while allows for capacitive coupling between the floating gate and a control gate.

The vertical floating gate layer 112 may be formed with a thickness within the range of 1 - 5 nm. This thickness range mitigates problems associated with parasitic interference between adjacent memory cells while providing efficient charge storage.

The second vertical dielectric layer 114 may be formed with a thickness within the range of 6 - 10 nm, which allows for proper isolation of the floating gate while allowing for injection or extraction of charges to/from the floating gate during programming operations of the floating gate memory comprising the floating gate memory element.

The forming 208 of the vertical floating gate layer 112 may comprise forming a semiconductor layer and a metal comprising layer. By providing a plurality of layers a floating gate memory with reduced charge leakage may be provided. Improved program/erase operation as well as retention performance may further be achieved.

A floating gate may comprise a stack of semiconductor and metal layers, which is commonly referred to as a hybrid floating gate. The stack may comprise Si and TiN or Si and Ru.

The use of a metal offers the possibility to tailor the band diagram for the floating gate of a floating gate memory as explained in P. Blomme et al, VLSI technology symposium 2010. The metal comprising layer may be deposited in a number of ways depending on the choice of metal - evaporation, sputtering, chemical vapour deposition (CVD), atomic layer deposition (ALD) etc.

The metal comprising layer may comprise TiN and/or TaN. The person skilled in the art realizes that the present invention by no means is limited to the preferred embodiments described above. On the contrary, many modifications and variations are possible within the scope of the appended claims.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Also two or more steps may be performed concurrently or with partial concurrence. Further, the steps of the method may be performed in an order different from what has been disclosed. Such variation will depend on the process hardware systems chosen and on designer choice. All such variations are within the scope of the disclosure. Additionally, even though the invention has been described with reference to specific exemplifying embodiments thereof, many different alterations, modifications and the like will become apparent for those skilled in the art.

## Claims

1. A method for manufacturing a floating gate memory element, the method (200) comprising:
forming (202) a stack of horizontal layers (100) arranged on top of each other, the stack of horizontal layers (100) comprising alternating sacrificial layers of a first type (102) and sacrificial layers of a second type (104);
forming (204) a vertical opening (106) through said horizontal stack of layers (100), wherein said vertical opening (106) comprises a sidewall surface (108),
forming (206) a first vertical dielectric layer (110) on said sidewall surface (108),
forming (208) a vertical floating gate layer (112) on said first vertical dielectric layer (110),
forming (210) a second vertical dielectric layer (114) on said vertical floating gate layer (112),
filling (211) said vertical opening (106) with a channel material (107),
forming (212) cavities of a first type (105) in said sacrificial layers of the second type (104), said cavities (105) being adjacent to said first vertical dielectric layer (110),
removing (214) portions of said first vertical dielectric layer (110) and said vertical floating gate layer (112) at locations adjacent to said cavities of the first type (105) thereby extending said cavities of the first type (105) such that said second vertical dielectric layer (114) is exposed,
filling (216) said extended cavities of the first type (105) with an isolating material (116),
forming (218) cavities of a second type (117) in said sacrificial layers of the first type (102), said cavities of the second type (117) being adjacent to and exposing said first vertical dielectric layer (110),
forming (220) a third dielectric layer (118) in said cavities of the second type (117), said third dielectric layer (118) being formed on said first vertical dielectric layer (110),
forming (222) a conductive material (120) in said cavities of the second type (117), said conductive material (120) being in contact with said third dielectric layer (118).

2. The method according to claim 1, wherein said removing (214) of portions of said first vertical dielectric layer (110) and said vertical floating gate layer (112) comprises isotropic etching.

3. The method according to claim 1 or 2, wherein said first vertical dielectric layer (110) and said third dielectric layer (118) are formed with a total thickness tₜₒₜ and wherein a thickness of said first vertical layer t₁ is in the range of 20 - 60 % of the total thickness tₜₒₜ.

4. The method according to claim 1 or 2, further comprising removing of said first vertical dielectric layer (110) at exposed locations of said first vertical dielectric layer (110) prior to forming said third dielectric layer (118), said third dielectric layer being formed with a total thickness tₜₒₜ.

5. The method according to claim 3 or 4, wherein the total thickness tₜₒₜ is within the range of 10 - 20 nm.

6. The method according to any of the preceding claims, wherein the vertical floating gate layer (112) is formed with a thickness within the range of 1 - 5 nm.

7. The method according to any of the preceding claims, wherein the second vertical dielectric layer (114) is formed with a thickness within the range of 6 - 10 nm.

8. The method according to any one of the preceding claims, wherein said conductive material (120) comprises a metal.

9. The method according to any one of the preceding claims, wherein said forming (220) of said third dielectric layer (118) comprises forming a plurality of dielectric layers.

10. The method according to any one of the preceding claims, wherein said forming (208) of said vertical floating gate layer (112) comprises forming a semiconductor layer and a metal comprising layer.

11. The method according to any one of the preceding claims, wherein said channel material (107) comprises an amorphous semiconductor material.

12. The method according to claim 11, further comprising transforming said amorphous semiconductor material to a poly-crystalline semiconductor material or a single-crystalline semiconductor material.
